# EUROPEAN PATENT SPECIFICATION

(11) **EP 3 096 452 B1**
(45) Date of publication and mention of the grant of the patent: **14.11.2018**
(21) Application number: 15168460.2
(22) Date of filing: 20.05.2015
(51) Int. Cl.: H03F 3/45, H04B 1/30

(54) **OPERATIONAL AMPLIFIER CIRCUIT WITH DC OFFSET SUPPRESSION**
OPERATIONSVERSTÄRKERSCHALTUNG MIT UNTERDRÜCKUNG DES DC-OFFSETS
CIRCUIT AMPLIFICATEUR OPÉRATIONNEL AVEC SUPPRESSION DE DÉCALAGE EN CONTINU

(43) Date of publication of application: 23.11.2016
(73) Proprietor: ALi Corporation, Hsinchu City 300 (TW)
(72) Inventor: Berner, Raphael, CH-1228 Geneva (CH)
(74) Representative: 2K Patentanwälte Blasberg Kewitz & Reichel

(56) References cited:
- JP-A- 2007 243 636
- US-A1- 2008 157 846
- TIEN-YU LO ET AL: "A Wide Tuning Range G-C Filter for Multi-Mode CMOS Direct-Conversion Wireless Receivers", IEEE JOURNAL OF SOLID-STATE CIRCUITS, IEEE SERVICE CENTER, PISCATAWAY, NJ, USA, vol. 44, no. 9, 26 August 2009 (2009-08-26), pages 2515-2524, XP011275840, ISSN: 0018-9200, DOI: 10.1109/JSSC.2009.2023154
- LI-SHIN LAI ET AL: "An Experimental Ultra-Low-Voltage Demodulator in 0.18-m CMOS", IEEE TRANSACTIONS ON MICROWAVE THEORY AND TECHNIQUES, IEEE SERVICE CENTER, PISCATAWAY, NJ, US, vol. 57, no. 10, 1 October 2009 (2009-10-01), pages 2307-2317, XP011275733, ISSN: 0018-9480, DOI: 10.1109/TMTT.2009.2029023
- MEZBAH UDDIN SHABER ET AL: "Fully differential gain-boosted ota design for pipeline DA-converter in 180nm CMOS technology", ELECTRONICS, CIRCUITS AND SYSTEMS, 2005. ICECS 2005. 12TH IEEE INTERNATIONAL CONFERENCE ON, IEEE, PISCATAWAY, NJ, USA, 11 December 2005 (2005-12-11), pages 1-4, XP031327471, ISBN: 978-9972-611-00-1

## Description

### BACKGROUND OF THE DISCLOSURE

### FIELD OF THE DISCLOSURE

The disclosure generally relates to an operational amplifier (Op-Amp) circuit with direct current (DC) offset suppression, a low pass filter using the Op-Amp circuit and a radio frequency (RF) receiver using the Op-Amp circuit.

### DESCRIPTION OF RELATED ART

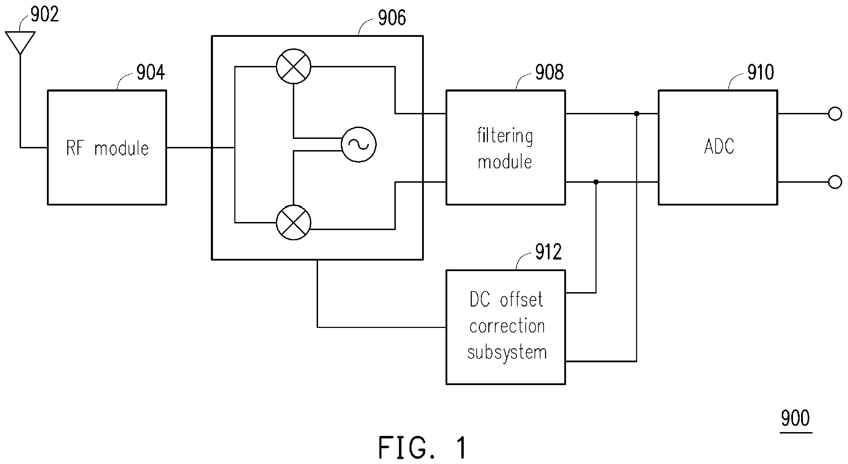

FIG. 1 shows a block diagram illustrating a RF receiver 900 which would include not limited to an antenna unit 902, a RF module 904, a mixer module 906, a filtering module 908, a DC offset correction subsystem 912, and optionally an analog-to-digital converter (ADC) 910. The RF receiver 900 would first receive a RF signal through the antenna unit 902 which may have one or more physical antennas, the RF signal would be processed by the RF module 904 which typically would include not limited to a band-pass filter and a low noise amplifier (LNA). The band-pass filter would limit the energy of the RF signal within a passband to avoid overloading the LNA, and the LNA would enhance the noise figure of the complete RF receiver.

The mixer module 906 module would receive the processed RF signal from the output of the RF module 904 and down-convert the RF signal to either an intermediate frequency (IF) band signal or directly to a baseband signal without going through an IF stage. The mixer module 906 may optionallybe implemented using one or more amplifiers.. The mixer module 906 also may possibly include one or more bandpass filters to further lower the noise floor and to minimize spurious radiations.

The filtering module 908 would receive the down-converted signal from the output of the mixer module 906 and may perform additional adjustments such as low pass filtering (LPF) and variable gain amplification (VGA) to generate a suitable baseband signal conforming to subsequent purposes. For example, assuming that the baseband signal is to be fed to an ADC 910 which is an optional component of the RF receiver 900, the filtering module 908 process the down-converted signal such that the down-converted signal may have the appropriate dynamic range for the analog to digital converter (ADC) 910.

DC offset could be a common issue induced within the RF receiver 900 by saturating the RF receiver 900 and degrading down-conversion performance of the RF receiver 900. In some cases, a DC offset correction subsystem 912 could be provided to calibrate component imbalances for the mixer 906 and the filtering module 908. The DC offset correction subsystem 912 may be coupled to the mixer module 906 to adjust component mismatches such as resistor imbalance according to DC offset measured from the output of mixer module 906 or the filtering module 908.

The DC offset correction subsystem 912 may be implemented by not limited to comparators, a digital state machine, and digital to analog converters (DAC), such that the architecture of the DC offset correction subsystem 912 could be potentially complex and costly to develop especially since the analog part and the digital part of the DC offset correction subsystem 912 have to be co-designed.

Moreover, the VGA of the filtering module 908 could be implemented using a differential operational amplifier (Op-Amp) with a common-mode feedback circuit. The common-mode feedback circuit could be a single feedback loop that takes the average of the two output signals (differential output signal) of the Op-Amp, compares the average of the two output signals of the Op-Amp to a reference, and controls some bias transistors of the Op-Amp to move the average of the two output signals of the Op-Amp close to the reference. The common-mode feedback circuit may not consider the DC offset because the average of the two output signals of the Op-Amp is DC offset free.

In the article "Fully differential gain-boosted ota design for pipeline DA-converter in 180nm CMOS technology" by Mezbah Uddin Shaber et al, published in a conference paper for the 12TH IEEE INTERNATIONAL CONFERENCE ON ELECTRONICS, CIRCUITS AND SYSTEMS, 2005, ICECS 2005, in PISCATAWAY, NJ, USA, 11 December 2005 (2005-12-11), XP031327471, ISBN: 978-9972-611-00-1, there is described on pages 1-4 a fully differential gain-boosted improved OTA for high performance pipeline DA-converter in UMC 180 nm technology for a 3.3 V power supply applications. The architecture chosen for the design is a folded cascode OTA structure for the main and gain boosting stages. The designed OTA achieved a very high DC gain greater than 95 db with a unity gain band width of 500 MHz for a 500 fF load with a power consumption of 14.5 mW and phase margin of more then 55 degrees, which meets the design specifications. The design is meant to be used for implementation of a pipeline DA-converter, using selection inversion based on Gray coded bit vector. Simulation is done using Cadence Affirm Spectre circuit simulator. Layout of the OTA structure has been finished and prepared to be taped out.

In the article "A Wide Tuning Range G-C Filter for Multi-Mode CMOS Direct-Conversion Wireless Receivers" by Tien-Yu Lo et al, published in the IEEE Journal of Solid-State Circuits, Vol. 44, No. 9, August 26, 2009, on pages 2515-2524, there is disclosed a third-order channel selection filter for multi-mode direct-conversion receivers. The filter is designed with a Butterworth prototype and with the target wireless applications of Bluetooth, cdma2000, Wideband CDMA, and IEEE 802.11 a/b/g/n wireless LANs. Linear-region MOS transistors are used to perform voltage-to-current conversion.

JP 2007 243 636 A discloses a differential amplification circuit and DC offset cancelling method which simplifies the supply means of a reference voltage that becomes a reference for comparing with the output voltage of the differential amplification circuit. Therefore, a comparator is used to cancel the DC offset of the differential amplification circuit when a feedback voltage, which feeds back the output of the differential amplification circuit to an input side, is formed. The comparator supplies a common voltage as a reference voltage that becomes a reference for comparing with the output voltage of the differential amplification circuit in the comparator. In this case, the common voltage is a middle point voltage, where the voltage between a first output and a second output end of the differential amplification circuit is divided into two equally at each drain side of a first FET and a second FET of which sources are connected to form a differential pair.

General background prior art is represented, by e.g. US 2008 / 157 846 A1.

### SUMMARY OF THE DISCLOSURE

Accordingly, the disclosure is directed to an operational amplifier circuit with DC offset suppression as defined in independent claim 1, a low pass filter using the same and a RF receiver using the operational amplifier circuit with DC offset suppression for solving the problems as aforementioned. The operational amplifier circuit with DC offset suppression of the disclosure would include not limited to a first operational amplifier and a pair of feedback circuits. The first operational amplifier may include not limited to an input stage and an output stage. The input stage could be configured to receive differential input signals. The output stage could be coupled to the input stage and configured to output a pair of differential output signals. The feedback circuits could be coupled to the output stage of the first operational amplifier. Each of the feedback circuits could output a feedback signal responding to a difference between a reference voltage and one of the pair of differential output signals. One of a pair of first bias currents of the output stage could be adjusted based on the feedback signals and another of the pair of first bias currents could be adjusted based on another of the feedback signals, so that a DC offset of the one of the pair of differential output signals isreduced based on a first feedback signal instead of a second feedback signal, and that a DE offset of another of the pair of differential output signals is reduced based on the second feedback signal instead of the first feedback signal.

In one of the exemplary embodiments of the disclosure, the feedback circuit would be a low frequency low-pass filter, and a cut-off frequency of the low frequency low-pass filter would be lower than a frequency of the differential input signal.

In one of the exemplary embodiments of the disclosure, each of the pair of feedback circuits may include not limited to a capacitor and a second operational amplifier. A first end of the capacitor could be coupled to a ground terminal. A non-inverting input end of the second operational amplifier could be coupled to the first operational amplifier to receive the one of the pair of differential output signals. An inverting input end of the first operational amplifier could be configured to receive the reference voltage. An output end of the second operational amplifier could be coupled to a second end of the capacitor to generate and output the feedback signal.

In one of the exemplary embodiments of the disclosure, each of the pair of feedback circuits would include not limited to a capacitor and a differential amplifier. A first end of the capacitor could be coupled to a power terminal. A first input end of the differential amplifier could be coupled to the first operational amplifier to receive the one of the pair of differential output signals. A second input end of the differential amplifier could be configured to receive the reference voltage. An output end of the differential amplifier could be coupled to a second end of the capacitor to generate and output the feedback signal. The output end of the differential amplifier could be located at a current path corresponding to the second input end of the differential amplifier.

In one of the exemplary embodiments of the disclosure, each of the differential amplifiers would include not limit to a first transistor, a second transistor, a current source circuit and a load circuit. A gate end of the first transistor could be coupled to the first operational amplifier through the first input end to receive the one of the pair of differential output signals. A gate end of the second transistor could be configured to receive the reference voltage through the second input end. The current source circuit may be configured to generate a second bias current to bias the first transistor and the second transistor. A first load end of the load circuit could be coupled to a drain end of the first transistor. A second load end of the load circuit could be coupled to a drain end of the second transistor to be the output end of the differential amplifier. A source end of the first transistor could be coupled to a bias node. A source end of the second transistor could be coupled to the source end of the first transistor. The current source circuit may be coupled to the bias node.

In one of the exemplary embodiments of the disclosure, the operational amplifier circuit with DC offset suppression may further include not limited to a bias current generating circuit. The bias current generating circuit could be coupled to the current source circuits of the differential amplifiers respectively. The bias current generating circuit could be configured to generate a reference current responding to a bias signal. Each of the current source circuits may generate the second bias current responding to the reference current.

In one of the exemplary embodiments of the disclosure, the bias current generating circuit may include not limited to a bias transistor and a reference transistor. A gate end of the bias transistor could be configured to receive the bias signal. A source end of the bias transistor could be coupled to the power terminal. A source end of the reference transistor could be coupled to a ground terminal. A gate end and a drain end of the reference transistor could be coupled to a drain end of the bias transistor and coupled to the current source circuits of the differential amplifiers respectively.

In one of the exemplary embodiments of the disclosure, each of the current source circuits may include not limited to a third transistor and a fourth transistor. A gate end of the third transistor could be coupled to the gate end of the reference transistor. A drain end of the third transistor could be coupled to the bias node. A drain end and a gate end of the fourth transistor could be coupled to each other and coupled to a source end of the third transistor. A source end of the fourth transistor could be coupled to the ground terminal.

The radio frequency receiver of the disclosure may include not limited to a mixer and a filtering module. The mixer could be configured to down-convert an RF signal into a base band signal. The filtering module could be coupled to the mixer to receive the base band signal. The filtering module could be configured to filter and amplify the base band signal to generate a filtered signal. The filtering module may include not limited to a low pass filter and a gain amplifier. The low pass filter would be configured to receive and filter a first signal or the base band signal and generate a second signal or the filtered signal accordingly. The gain amplifier may include not limited to an operational amplifier circuit with DC offset suppression of the above-mentioned disclosure and a gain control circuit. The operational amplifier circuit with DC offset suppression of the disclosure would include not limited to a first operational amplifier and a pair of feedback circuits. The first operational amplifier may include not limited to an input stage and an output stage. The input stage could be configured to receive differential input signals. The output stage could be coupled to the input stage and configured to output a pair of differential output signals as the first signal or the filtered signal. The feedback circuits could be coupled to the output stage of the first operational amplifier. Each of the feedback circuits could generate a feedback signal according to a reference voltage and one of the pair of differential output signals. A pair of first bias currents of the output stage could be adjusted based on the corresponding feedback signal to close a DC voltage level of the one of the pair of differential output signals to a voltage level of the reference voltage. The gain control circuit may be configured to receive the base band signal or the second signal. The gain control circuit may be coupled between the input stage and the output stage. The gain control circuit would operate in coordination with the operational amplifier circuit to determine a gain value of the gain amplifier. The gain amplifier could be coupled between the mixer and the low pass filter to receive the base band signal, and could be configured to amplify the base band signal to generate the first signal. Or, the gain amplifier could be coupled to the low pass filter to receive the second signal, and could be configured to amplify the second signal to generate the filtered signal.

The low pass filter of the disclosure may include not limited to an operational amplifier circuit with DC offset suppression of the above-mentioned disclosure and a filtering circuit. The operational amplifier circuit with DC offset suppression of the disclosure would include not limited to a first operational amplifier and a pair of feedback circuits. The first operational amplifier may include not limited to an input stage and an output stage. The input stage could be configured to receive differential input signals. The output stage could be coupled to the input stage and configured to output a pair of differential output signals as the first signal or the filtered signal. The feedback circuits could be coupled to the output stage of the first operational amplifier. Each of the feedback circuits could generate a feedback signal according to a reference voltage and one of the pair of differential output signals. A pair of first bias currents of the output stage could be adjusted based on the corresponding feedback signal to close a DC voltage level of the one of the pair of differential output signals to a voltage level of the reference voltage. The filtering circuit may be configured to receive an external signal. The filtering circuit may be coupled between the input stage and the output stage. The filtering circuit would operate in coordination with the operational amplifier circuit to amplify and filter the external signal.

Based on the above-mentioned disclosure, the Op-Amp with DC offset suppression according to the disclosure would be a fully differential Op-Amp architecture which suppresses the DC offset. The Op-Amp may reduce DC offset by implementing a separate feedback circuit for each output signal instead of using a common-mode feedback circuit. Each of the feedback circuits would be a low frequency low-pass filter, and a cut-off frequency of the low frequency low-pass filter would be lower than a frequency of the differential input signals. Thus, only the DC offset of the output signal would be suppressed and the relevant part of the output signal may not be removed. Besides, the low pass filter and the RF receiver according to the disclosure may utilize the same operational amplifier circuit with DC offset suppression in order to reduce the DC offset, such that the low pass filter and the RF receiver of the disclosure would not require an extra DC offset correction subsystem. Therefore, the low pass filter and the RF receiver of the disclosure would be an analog circuit that could be smaller, simpler, and easier to design as the hardware cost of the low pass filter and the RF receiver may also be reduced.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
FIG. 1 shows a block diagram illustrating a RF receiver module.
FIG. 2 shows a block diagram illustrating an operational amplifier circuit with DC offset suppression according to one of the exemplary embodiments of the disclosure.
FIG. 3 shows a timing diagram of related waveforms of the operational amplifier circuit of FIG. 2 and an operational amplifier without DC offset suppression.
FIG. 4 shows a transient timing diagram of the operational amplifier circuit of FIG. 2 and the operational amplifier without DC offset suppression.
FIG. 5 shows a closed-loop frequency response diagram of the operational amplifier circuit of FIG. 2 and the operational amplifier without DC offset suppression.
FIG. 6 shows a block diagram illustrating an operational amplifier circuit with DC offset suppression according to one of the exemplary embodiments of the disclosure.
FIG. 7 shows a block diagram illustrating a RF receiver according to one of the exemplary embodiments of the disclosure.
FIG. 8A to FIG. 8E show block diagrams illustrating the filtering module of FIG. 7.
FIG. 9 shows a schematic diagram illustrating a gain amplifier according to one of the exemplary embodiments of the disclosure.
FIG. 10 shows a block diagram illustrating a low pass filter according to one of the exemplary embodiments of the disclosure.

### DESCRIPTION OF THE EMBODIMENTS

Reference will now be made in detail to the present preferred embodiments of the disclosure, examples of which are illustrated in the accompanying drawings. Wherever possible, the same reference numbers are used in the drawings and the description to refer to the same or like parts.

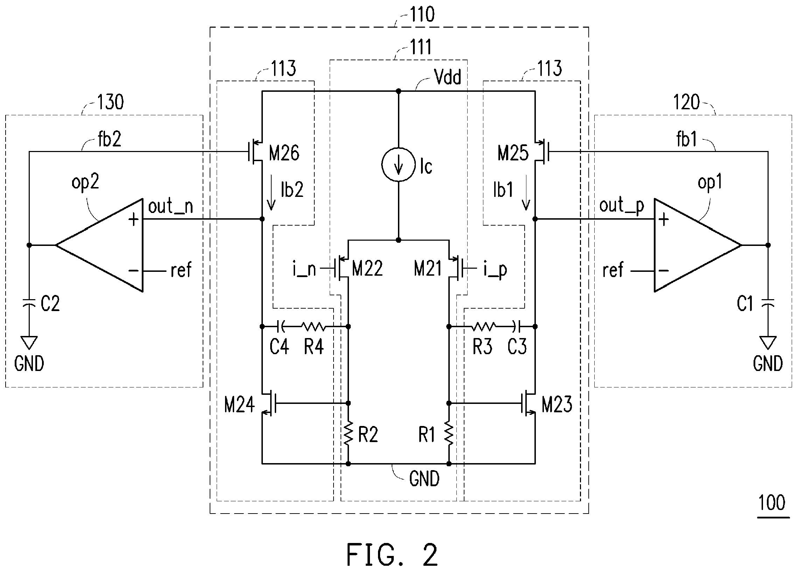

FIG. 2 shows a block diagram illustrating an operational amplifier circuit 100 with DC offset suppression according to one of the exemplary embodiments of the disclosure. The operational amplifier circuit 100 would include not limited to a first operational amplifier 110 and feedback circuits 120 and 130. The first operational amplifier 110 may include not limit to an input stage 111 and an output stage 113. The input stage 111 could be configured to receive differential input signals i_p and i_n. The output stage 113 would be coupled to the input stage 111 and configured to output a pair of differential output signals out_p and out_n.

The feedback circuit 120 could be coupled to the output stage 113 to receive one of the pair of differential output signals (i.e., the output signal out_p). In one embodiment, the feedback circuit 120 could be configured to amplify a time average of a voltage difference between a reference voltage ref and the output signal out_p to generate a feedback signal fb1. The feedback circuit 120 would output the feedback signal fb1 to the output stage 113 to adjust a first bias current Ib1 of the output stage 113 corresponding to the output signal out_p, such that a DC voltage level of the output signal out_p would be close to a voltage level of the reference voltage ref and a DC offset of the output signal out_p could be suppressed.

Similarly, the feedback circuit 130 could be coupled to the output stage 113 to receive one of the pair of differential output signals (i.e., the output signal out_n). In one embodiment, the feedback circuit 130 could be configured to amplify a time average of a voltage difference between a reference voltage ref and the output signal out n to generate a feedback signal fb2. The feedback circuit 130 would output the feedback signal fb2 to the output stage 113 to adjust a first bias current Ib2 of the output stage 113 corresponding to the output signal out_n, such that a DC voltage level of the output signal out_n could be close to a voltage level of the reference voltage ref and a DC offset of the output signal out_n could be suppressed.

Herein, it may be understood that, the operational amplifier circuit 100 with DC offset suppression in FIG. 2 would be implemented as a fully differential Op-Amp architecture which suppresses DC offset. The operational amplifier circuit 100 may reduce DC offset by implementing a separate feedback loop (i.e., the feedback circuit 120 and 130) for each output signal (i.e., the output signal out_p and out n) instead of a common-mode feedback circuit. Each of the feedback circuits 120, 130 could be a low frequency low-pass filter, and a cut-off frequency of the low frequency low-pass filter would be lower than a frequency of the differential input signals i_p and i_n. Thus, only the DC offsets of the output signals out_p, out n would be suppressed and the relevant part of the output signals out_p, out n may not be removed.

To describe in further details, as shown in FIG. 2, the input stage 111 of the first operational amplifier 110 would include not limit to a current source Ic, input transistors M21, M22 and resistors R1, R2, wherein the input transistors M21, M22 may be PMOS, but the disclosure is not limited thereto. A first end of the current source Ic could be coupled to a power terminal Vdd. A second end of the current source Ic, a source end of the input transistor M21, and a source end of the input transistor M22 could be coupled to each other. A gate end of the input transistor M21 may receive the input signal i_p and a gate end of the input transistor M22 may receive the input signal i_n. A drain end of the input transistor M21 would be coupled to a first end of the resistor R1. The second end of the resistor R1 would be coupled to the ground terminal GND. A drain end of the input transistor M22 would be coupled to a first end of the resistor R2. The second end of the resistor R2 would be coupled to the ground terminal GND.

The output stage 113 would include not limit to bias transistors M25 and M26, transistors M23 and M24, capacitors C3 and C4, and resistors R3 and R4, wherein the bias transistors M25, M26 would be PMOS and the transistors M23 and M24 would be NMOS, but the disclosure is not limited thereto.

A source end of the bias transistor M25 would be coupled to the power terminal Vdd. A gate end of the bias transistor M25 would receive the feedback signal fb 1 and the conductance of the bias transistor M25 would be controlled by the feedback signal fb1. A drain end of the bias transistor M25, a first end of the capacitor C3, and a drain end of the transistor M23 could be coupled to each other to provide the output signal out_p to the feedback circuit 120. A gate end of the transistor M23 would be coupled to the drain end of the input transistor M21 of the input stage 111. A source end of the transistor M23 would be coupled to the ground terminal GND. A second end of the capacitor C3 would be coupled to a first end of the resistor R3. A second end of the resistor R3 would be coupled to the drain end of the input transistor M21 of the input stage 111.

A source end of the bias transistor M26 would be coupled to the power terminal Vdd. A gate end of the bias transistor M26 would receive the feedback signal fb2 and the conductance of the bias transistor M26 would be controlled by the feedback signal fb2. A drain end of the bias transistor M26, a first end of the capacitor C4, and a drain end of the transistor M24 could be coupled to each other to provide the output signal out_n to the feedback circuit 130. A gate end of the transistor M24 would be coupled to the drain end of the input transistor M22 of the input stage 111. A source end of the transistor M24 would be coupled to the ground terminal GND. A second end of the capacitor C4 would be coupled to a first end of the resistor R4. A second end of the resistor R4 would be coupled to the drain end of the input transistor M22 of the input stage 111.

The feedback circuit 120 would include not limited to a capacitor C1 and a second operational amplifier op1. A first end of the capacitor C1 would be coupled to a ground terminal GND. A non-inverting input end of the second operational amplifier op1 would be coupled to the first operational amplifier 110 to receive the output signal out_p. An inverting input end of the second operational amplifier op1 would be configured to receive the reference voltage ref. An output end of the second operational amplifier op1 would be coupled to a second end of the capacitor C1 and the gate end of the bias transistor M25 to generate and output the feedback signal fb1.

Similarly, the feedback circuit 130 would include not limited to a capacitor C2 and a second operational amplifier op2. A first end of the capacitor C2 would be coupled to the ground terminal GND. A non-inverting input end of the second operational amplifier op2 would be coupled to the first operational amplifier 110 to receive the output signal out_n. An inverting input end of the second operational amplifier op2 would be configured to receive the reference voltage ref. An output end of the second operational amplifier op2 would be coupled to a second end of the capacitor C2 and the gate end of the bias transistor M26 to generate and output the feedback signal fb2.

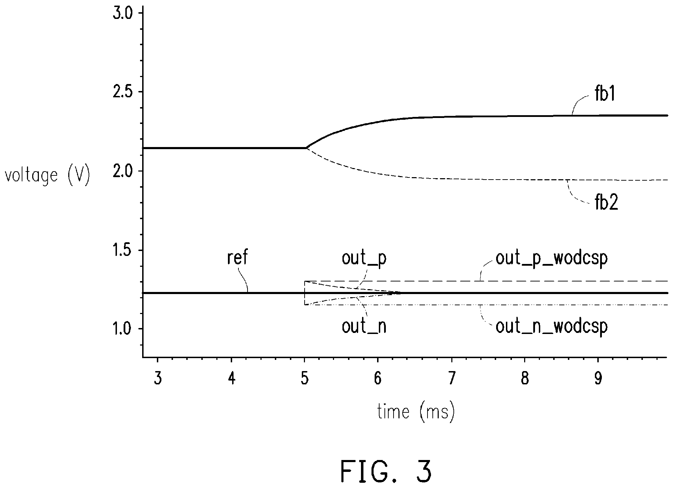

Hereinafter, the operation of the operational amplifier circuit 100 with DC offset suppression is described in detail. Referring to FIG. 2 and FIG. 3. FIG. 3 shows a timing diagram of related waveforms of the operational amplifier circuit 100 of FIG. 2 and an operational amplifier without DC offset suppression. The operational amplifier without DC offset suppression may be a normal Op-Amp (for example, the first operational amplifier 110 of FIG. 2). As shown in FIG. 3, at the time 5ms, a positive DC offset related to the reference voltage ref may be induced on the output signal out_p and a negative DC offset related to the reference voltage ref may be induced on the output signal out_n. The second operational amplifier op1 and the capacitor C1 may amplify the time average of the positive voltage difference between the reference voltage ref and the output signal out_p to generate the feedback signal fb1, such that the voltage level of the feedback signal fb1 may be increased over time and the first bias current Ib1 generated by the bias transistor M25 may be decreased. Thus, the DC voltage level of the output signal out_p may be decreased over time until it would be close to the voltage level of the reference voltage ref (i.e., the time average of the positive voltage difference between the reference voltage ref and the output signal out_p may be close to zero). On the contrary, the positive DC offset induced on the output signal out_p_wodcsp of the operational amplifier without DC offset suppression may not be removed, as shown in FIG. 3

On the other hand, the second operational amplifier op2 and the capacitor C2 may amplify the time average of a negative voltage difference between the reference voltage ref and the output signal out n to generate the feedback signal fb2, such that the voltage level of the feedback signal fb2 would be decreased over time and the first bias current Ib2 generated by the bias transistor M26 would be increased. Thus, the DC voltage level of the output signal out_n would be increased over time until it would be close to the voltage level of the reference voltage ref (i.e., the time average of the negative voltage difference between the reference voltage ref and the output signal out_n would be close to zero). On the contrary, the negative DC offset induced on the output signal out_n_wodcsp of the operational amplifier without DC offset suppression may not be removed, as shown in FIG. 3

Herein, it is worth mentioning that, for making the time average of the voltage difference between the reference voltage ref and the output signals out_p and out_n, the second operational amplifiers op1 and op2 may have a very low bias current (not shown) in the order of a few nano-ampere (nA), but the disclosure is not limited thereto. In combination with the capacitors C1, C2, each of the feedback circuits 120 and 130 may be a low frequency low-pass filter. In other words, the low pass corner of the feedback circuits 120 would be controlled by the bias current of the second operational amplifier op1 and the size of the capacitor C1. Similarly, the low pass corner of the feedback circuits 130 would be controlled by the bias current of the second operational amplifier op2 and the size of the capacitor C2.

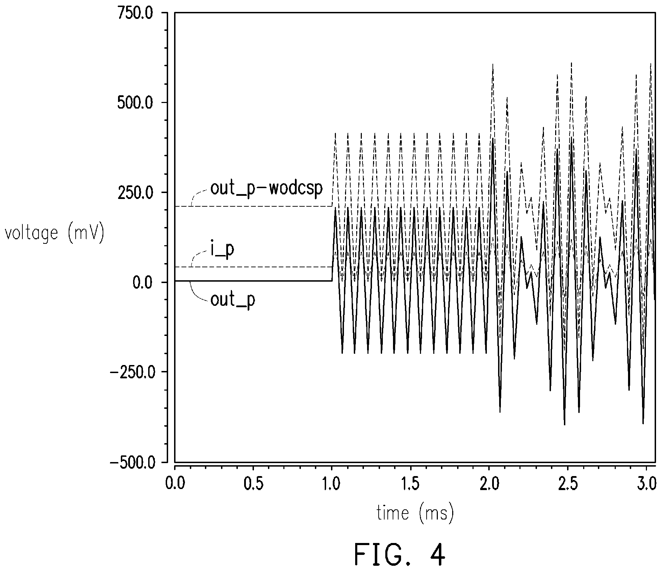

Referring to FIG. 2 and FIG. 4. FIG. 4 shows a transient timing diagram of the operational amplifier circuit 100 of FIG. 2 and the operational amplifier without DC offset suppression. As shown in FIG. 4, a positive DC offset 40mV related to the reference voltage ref (0V) would be induced on the input signal i_p. However, the DC offset of the output signal out_p of the operational amplifier circuit 100 of FIG. 2 may be reduced to about 4mV. On the contrary, the DC offset of the output signal out_p_wodcsp of the operational amplifier without DC offset suppression may be amplified to about 210mV.

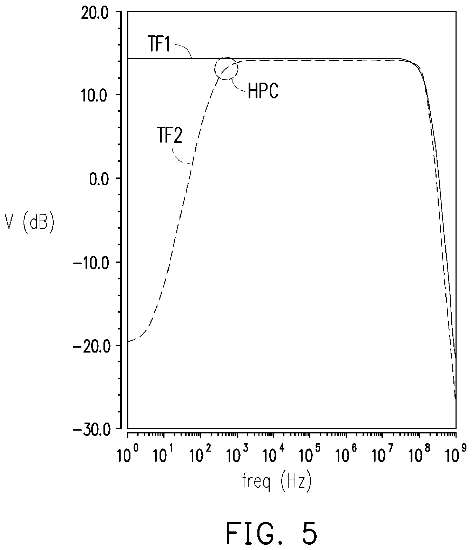

Referring to FIG. 2 and FIG. 5. FIG. 5 shows a closed-loop frequency response diagram of the operational amplifier circuit 100 of FIG. 2 and the operational amplifier without DC offset suppression. As shown in FIG. 5, compared with the closed-loop transfer function TF1 of the operational amplifier without DC offset suppression, the closed-loop transfer function TF2 of the operational amplifier circuit 100 of FIG. 2 may have a high pass corner HPC at the frequency of a few kHz. In other words, signals with frequencies lower than a few kHz may be suppressed by the operational amplifier circuit 100 of FIG. 2.

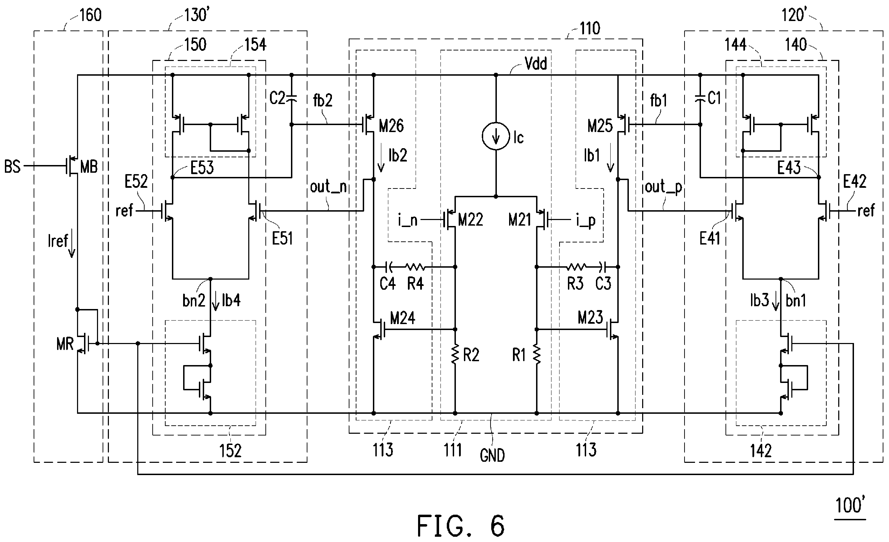

Referring to FIG. 6, FIG. 6 shows a block diagram illustrating an operational amplifier circuit 100' with DC offset suppression according to another exemplary embodiment of the disclosure. The operational amplifier circuit 100' with DC offset suppression would include not limited to a first operational amplifier 110 and a feedback circuit 120' and 130'. The first operational amplifier 110 of the operational amplifier circuit 100' would be similar to that illustrated in FIG. 2. Therefore, the description of the first operational amplifier 110 of the operational amplifier circuit 100' in FIG. 6 may refer to the above related description, which is not repeated hereinafter.

The feedback circuit 120' would be coupled to the output stage 113 of the first operational amplifier 110 to receive one of the pair of differential output signals (i.e., the output signal out_p). In one embodiment, the feedback circuit 120' would be configured to amplify a time average of a voltage difference between a reference voltage ref and the output signal out_p to generate a feedback signal fb1. The feedback circuit 120' may output the feedback signal fb1 to the output stage 113 to adjust a first bias current Ib1 of the output stage 113 corresponding to the output signal out_p), such that a DC voltage level of the output signal out_p would be close to a voltage level of the reference voltage ref and a DC offset of the output signal out_p would be suppressed.

Similarly, the feedback circuit 130' would be coupled to the output stage 113 of the first operational amplifier 110 to receive one of the pair of differential output signals (i.e., the output signal out_n). In one embodiment, the feedback circuit 130' would be configured to amplify a time average of a voltage difference between a reference voltage ref and the output signal out_n to generate a feedback signal fb2. The feedback circuit 130' may output the feedback signal fb2 to the output stage 113 to adjust a first bias current Ib2 of the output stage 113 corresponding to the output signal out_n), such that a DC voltage level of the output signal out_n would be close to a voltage level of the reference voltage ref and a DC offset of the output signal out n would be suppressed.

For details, as shown in FIG. 6, the feedback circuit 120' would include not limited to a capacitor C1 and a differential amplifier 140. A first end of the capacitor C1 would be coupled to a power terminal Vdd. A first input end E41 of the differential amplifier 140 would be coupled to the first operational amplifier 110 (i.e., the drain end of the bias transistor M25) to receive the output signal out_p. A second input end E42 of the differential amplifier 140 would be configured to receive the reference voltage ref. An output end E43 of the differential amplifier 140 would be coupled to a second end of the capacitor C1 to generate and output the feedback signal fb1 to the gate end of the bias transistor M25, wherein the output end E43 would be located at a current path corresponding to the second input end E42 of the differential amplifier 140. Accordingly, when a positive DC offset related to the reference voltage ref is induced on the output signal out_p, a current flowed through the current path corresponding to the second input end E42 of the differential amplifier 140 would be decreased, such that the time average of the voltage level corresponding to the feedback signal fb1 on the output end E43 may be increased over time and the first bias current Ib1 generated by the bias transistor M25 may be decreased. Thus, the DC voltage level of the output signal out_p may be decreased over time until it would be close to the voltage level of the reference voltage ref (i.e., the time average of the positive voltage difference between the reference voltage ref and the output signal out_p may be close to zero).

On the contrary, when a negative DC offset related to the reference voltage ref is induced on the output signal out_p, a current flowed through the current path corresponding to the second input end E42 of the differential amplifier 140 would be increased, such that the time average of the voltage level corresponding to the feedback signal fb1 on the output end E43 may be decreased over time and the first bias current Ib1 generated by the bias transistor M25 may be increased. Thus, the DC voltage level of the output signal out_p may be increased over time until it would be close to the voltage level of the reference voltage ref (i.e., the time average of the negative voltage difference between the reference voltage ref and the output signal out_p may be close to zero).

In one of the exemplary embodiments of the disclosure, the differential amplifier 140 may include not limited to a first transistor M41, a second transistor M42, a current source circuit 142, and a load circuit 144. In one embodiment, a gate end of the first transistor M41 would be coupled to the first operational amplifier 110 through the first input end E41 to receive the output signal out_p. A source end of the first transistor M41 would be coupled to a bias node bn1. A gate end of the second transistor M42 would be configured to receive the reference voltage ref through the second input end E42. A source end of the second transistor M42 would be coupled to the source end of the first transistor M41. The current source circuit 142 would be coupled to the bias node bn1. The current source circuit 142 would be configured to generate a second bias current Ib3 to bias the first transistor M41 and the second transistor M42. The load circuit 144 would be coupled to a drain end of the first transistor M41 and be coupled to a drain end of the second transistor M42 via the output end E43. The load circuit 144 may be an active load circuit, such as a current mirror circuit, but the disclosure is not limited thereto.

The feedback circuit 130' would include not limited to a capacitor C2 and a differential amplifier 150. In one of the exemplary embodiments of the disclosure, the differential amplifier 150 may include not limited to a first transistor M51, a second transistor M52, a current source circuit 152, and a load circuit 154. The feedback circuit 130' would be similar to the feedback circuit 120'. Therefore, the internal architecture of the feedback circuit 130' may refer to the related description of the feedback circuit 120', which is not repeated again.

The operational amplifier circuit 100' in FIG. 6 may further include not limited to a bias current generating circuit 160. The bias current generating circuit 160 would be coupled to the current source circuit 142 of the differential amplifier 140 and the current source circuit 152 of the differential amplifier 150. The bias current generating circuit 160 would be configured to generate a reference current Iref responding to a bias signal BS. Therefore, the current source circuit 142 may generate the second bias current Ib3 responding to the reference current Iref. Similarly, the current source circuit 152 may also generate the second bias current Ib4 responding to the reference current Iref.

For details, the bias current generating circuit 160 may include not limited to a bias transistor MB and a reference transistor MR. A gate end of the bias transistor MB would be configured to receive the bias signal BS. A source end of the bias transistor MB would be coupled to the power terminal Vdd. A source end of the reference transistor MR would be coupled to a ground terminal GND. A gate end and a drain end of the reference transistor MR could be coupled to a drain end of the bias transistor MB and coupled to the current source circuits 142 and 152.

The current source circuit 142 may include not limited to a third transistor M43 and a fourth transistor M44. A gate end of the third transistor M43 would be coupled to the gate end of the reference transistor (MR) of the bias current generating circuit 160. A drain end of the third transistor M43 would be coupled to the bias node bn1. A drain end and a gate end of the fourth transistor M44 would be coupled to each other and coupled to a source end of the third transistor M43. A source end of the fourth transistor M44 would be coupled to the ground terminal GND. It should be understood that, the third transistor M43, the fourth transistor M44, and the reference transistor MR may construct a current mirror. Therefore, persons skilled in the art may modify and retouch the current source circuit 142 and the bias current generating circuit 160 to construct any kind of current mirror for generating the second bias current Ib3. The current source circuit 152 would be similar to the current source circuit 142. Therefore, the operation and the internal architecture of the current source circuit 152 may refer to the above description of the current source circuit 142, which is not repeated again.

As description above, for making the time average of the voltage difference between the reference voltage ref and the output signals out_p, out_n, each of the differential amplifiers 140, 150 may have a very low (e.g. in the order of a few nano-ampere (nA)) bias current Ib3, Ib4 which would be controlled by the bias signal BS. In combination with the capacitors C1, C2, each of the feedback circuits 120' and 130' may be a low frequency low-pass filter. In other words, the low pass corner of the feedback circuits 120' would be controlled by the bias current Ib3 of the differential amplifier 140 (or the bias signal BS) and the size of the capacitor C1. Similarly, the low pass corner of the feedback circuits 150 would be controlled by the bias current Ib4 of the differential amplifier 150 (or the bias signal BS) and the size of the capacitor C2.

Operations of the operational amplifier circuit 100' in FIG. 6 are similar to those of the operational amplifier circuit 100 in FIG. 2. Therefore, operations of the operational amplifier circuit 100' in FIG. 6 may refer to the above related description of FIG. 2 to FIG. 5 or may be deduced by analogy, which is not repeated hereinafter.

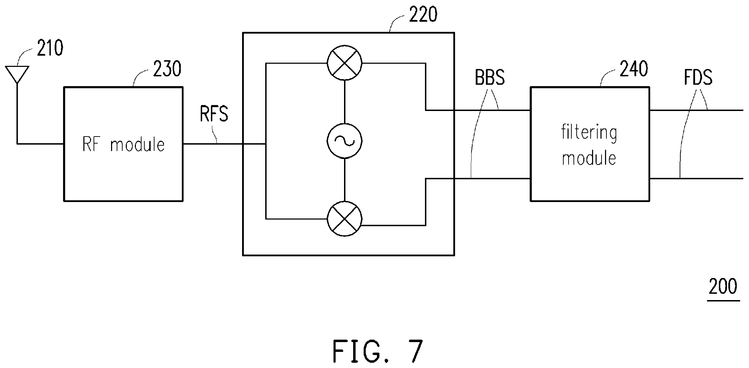

Please referring to FIG. 7, FIG. 7 shows a block diagram illustrating a radio frequency receiver 200 according to one of the exemplary embodiments of the disclosure. The radio frequency receiver 200 may include not limited to an antenna unit 210, a RF module 230, a mixer 220 and a filtering module 240. The antenna unit 210 and the RF module 230 would be respectively similar to those illustrated in FIG. 1. Therefore, the description of the antenna unit 210 and the RF module 230 in FIG. 7 may refer to the above related description, which is not repeated hereinafter. The mixer 220 would be configured to down-convert an RF signal RFS into a base band signal BBS. The filtering module 240 would be coupled to the mixer 220 to receive the base band signal BBS, and configured to filter and amplify the base band signal BBS to generate a filtered signal FDS.

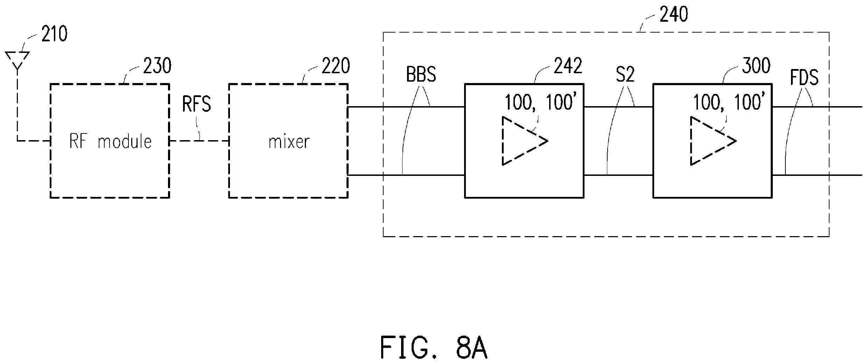

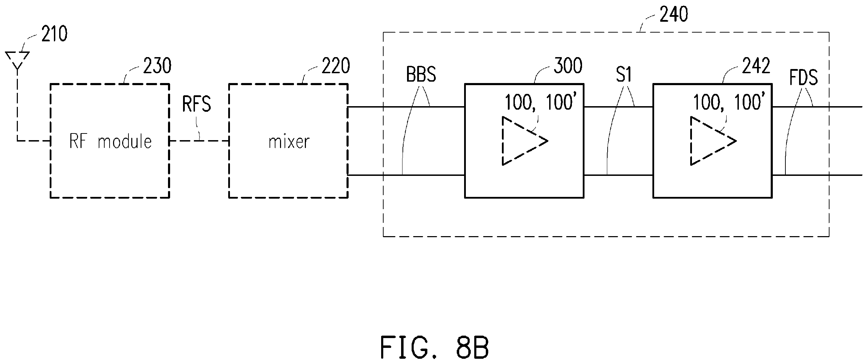

Referring to FIG. 7 and FIG. 8A to FIG. 8E together. FIG. 8A to FIG. 8E are block diagrams illustrating the filtering module 240 of FIG. 7. The filtering module 240 may include not limited to a low pass filter 242 and a gain amplifier 300 comprising an operational amplifier circuit 100, 100' as shown in FIG. 2 and FIG. 6, wherein the gain amplifier 300 may be a variable gain amplifier or a fixed gain amplifier. The low pass filter 242 would be configured to receive and filter the base band signal BBS or a first signal S1 (shown in FIG. 8B to 8E) and then generate a second signal S2 or the filtered signal FDS accordingly.

In one of the exemplary embodiments of the disclosure, as shown in FIG. 8A, the low pass filter 242 would be configured to receive and filter the base band signal BBS and then generate a second signal S2 accordingly. The gain amplifier 300 comprising the operational amplifier circuit 100, 100' would be coupled to the low pass filter 242 to receive the second signal S2, and would amplify the second signal S2 to generate the filtered signal FDS.

In another exemplary embodiment of the disclosure, as shown in FIG. 8B, the gain amplifier 300 comprising the operational amplifier circuit 100, 100' would be coupled between the mixer 220 and the low pass filter 242 to receive the base band signal BBS and amplify the base band signal BBS to generate the first signal S1. The low pass filter 242 would be configured to receive and filter the first signal S1 and generate the filtered signal FDS accordingly.

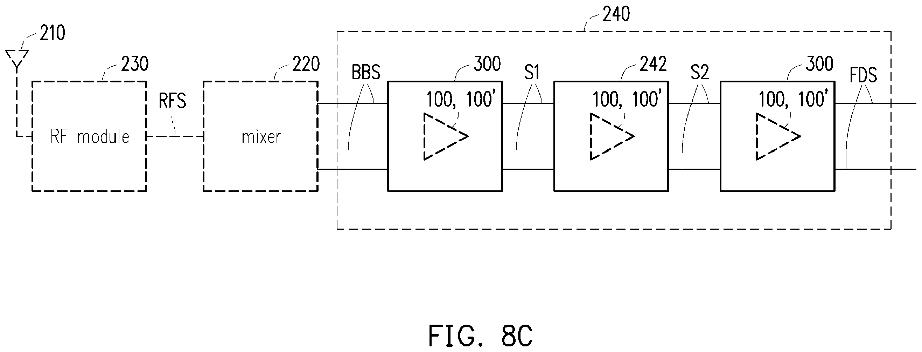

In yet another exemplary embodiment of the disclosure, as shown in FIG. 8C, the filtering module 240 would include but not limited to two gain amplifiers 300 comprising the operational amplifier circuit 100, 100'. One gain amplifier 300 would be coupled between the mixer 220 and the low pass filter 242, and configured to generate the first signal S1 based on the base band signal BBS. The other gain amplifier 300 would be configured to receive the second signal S2 which is generated by the low pass filter 242, and amplify the second signal S2 to generate the filtered signal FDS.

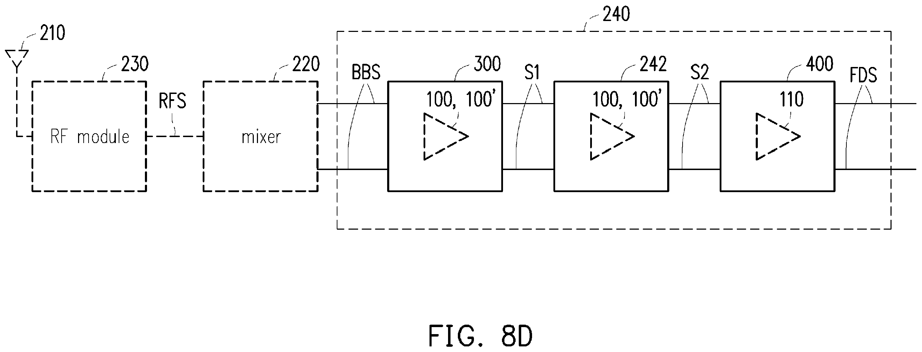

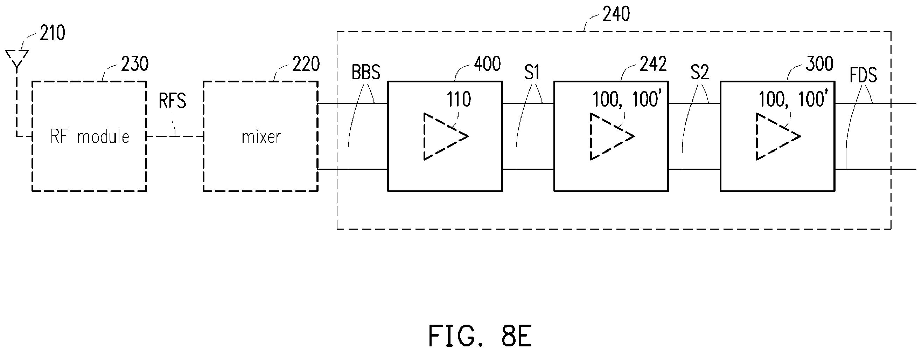

In yet another exemplary embodiment of the disclosure, as shown in FIG. 8D and 8E, the filtering module 240 would include but not limited to a gain amplifier 300 comprising the operational amplifier circuit 100, 100' and a gain amplifier 400 comprising an operational amplifier without DC offset suppression, wherein the gain amplifier 400 may be a variable gain amplifier or a fixed gain amplifier, and the operational amplifier without DC offset suppression may be a normal Op-Amp (for example, the first operational amplifier 110 of FIG. 2). As shown in FIG. 8D , the gain amplifier 300 would be coupled between the mixer 220 and the low pass filter 242, and configured to generate the first signal S1 based on the base band signal BBS. The gain amplifier 400 would be configured to receive the second signal S2 which is generated by the low pass filter 242, and amplify the second signal S2 to generate the filtered signal FDS. Or as shown in FIG. 8E , the gain amplifier 400 would be coupled between the mixer 220 and the low pass filter 242, and configured to generate the first signal S1 based on the base band signal BBS. The gain amplifier 300 would be configured to receive the second signal S2 which is generated by the low pass filter 242, and amplify the second signal S2 to generate the filtered signal FDS.

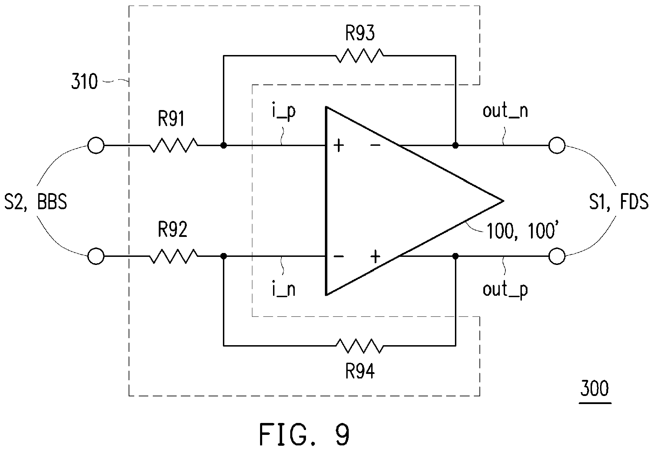

Please referring to FIG. 2, FIG. 6, FIG. 8A to 8E and FIG. 9 together, FIG. 9 shows a schematic diagram illustrating a gain amplifier 300 according to one of the exemplary embodiments of the disclosure. As shown in FIG. 9, the gain amplifier 300 may include not limited to an operational amplifier circuit 100, 100' with DC offset suppression (as shown in FIG. 2 and FIG. 6) and a gain control circuit 310. The gain control circuit 310 would be configured to receive the base band signal BBS or the second signal S2. The gain control circuit 310 could be coupled between the input stage 111 and the output stage 113 of the operational amplifier circuit 100, 100'. The gain control circuit 310 could operate in coordination with the operational amplifier circuit 100, 100' to determine a gain value of the gain amplifier 300. The operational amplifier circuit 100, 100' would output the pair of differential output signals out_p, out_n as the first signal S1 or the filtered signal FDS.

For details, in one of the exemplary embodiments of the disclosure, the gain control circuit 310 may include not limited to resistors R91, R92, R93 and R94, but the disclosure is not limited thereto. The resistors R91 and R92 would be configured to receive the base band signal BBS or the second signal S2 and respectively coupled to a non-inverting input end and an inverting input end of the operational amplifier circuit 100, 100' to generate the differential input signals i_p and i_n. The resistor R93 would be coupled between the non-inverting input end and an inverting output end of the operational amplifier circuit 100, 100'. The resistor R94 would be coupled between the inverting input end and a non-inverting output end of the operational amplifier circuit 100, 100'. As mentioned above, the gain amplifier 300 may be a variable gain amplifier or a fixed gain amplifier. If the gain amplifier 300 is a variable gain amplifier, at least one of the resistors R91, R92, R93 and R94 would be a variable resistor. On the contrary, if the gain amplifier 300 is a fixed gain amplifier, all of the resistors R91, R92, R93 and R94 would be a constant resistor.

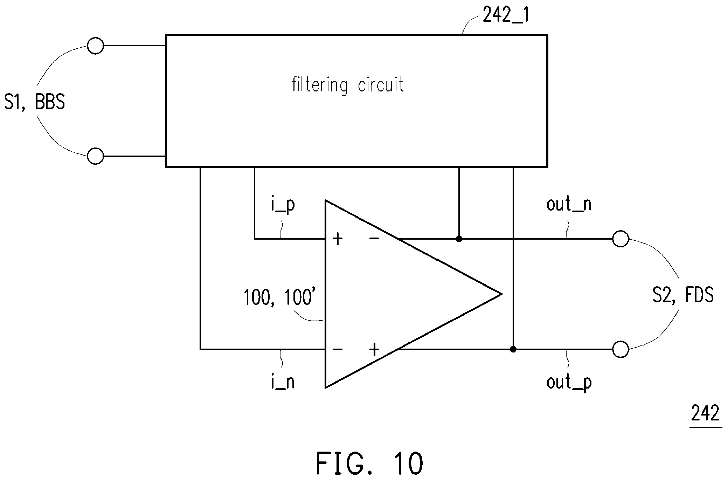

Please referring to FIG. 2, FIG. 6, FIG. 8A to 8E and FIG. 10 together, FIG. 10 shows a block diagram illustrating a low pass filter 242 according to one of the exemplary embodiments of the disclosure. As shown in FIG. 10, the low pass filter 242 could be an active low pass filter and would comprise an operational amplifier circuit 100, 100' as shown in FIG. 2 and FIG. 6 and a filtering circuit 242_1. The filtering circuit 242_1 could be configured to receive an external signal (such as the first signal S1 shown in FIG. 8B to FIG. 8E or the base band signal BBS shown in FIG. 8A). The filtering circuit 242_1 could be coupled between the input stage (111) and the output stage (113) of the operational amplifier circuit 100, 100'. The filtering circuit 242_1 would operate in coordination with the operational amplifier circuit 100, 100' to amplify and filter the external signal. The filtering circuit 242_1 could be implemented by passive components, such as resistors, capacitors or inductors.

Referring to FIG. 7 and FIG. 8A to FIG. 8E together again. Because the filtering module 240 of the radio frequency receiver 200, for the implementation of the gain amplifier 300 or the low pass filter 242, may adopt the operational amplifier circuit 100, 100' with DC offset suppression as shown in FIG. 2 and FIG. 6 to reduce the DC offset, such that the radio frequency receiver 200 in the disclosure would not require an extra DC offset correction subsystem 912 as shown in FIG. 1. Therefore, the radio frequency receiver 200 in the disclosure would be a complete analog circuit that would be smaller, simpler, and easier to design. In addition, the hardware cost of the radio frequency receiver 200 may also be reduced.

In summary, the operational amplifier circuit with DC offset suppression according to the embodiments of the disclosure would be a fully differential Op-Amp architecture which suppresses the DC offset. The operational amplifier circuit may reduce the DC offset by implementing a separate feedback circuit for each output signal instead of a common-mode feedback circuit. Each of the feedback circuits would be a low frequency low-pass filter, and a cut-off frequency of the low frequency low-pass filter would be lower than a frequency of the differential input signals. Thus, only the DC offset of the output signal would be suppressed and the relevant part of the output signal may not be removed. Besides, the radio frequency receiver according to the embodiments of the disclosure may adopt the operational amplifier circuit with DC offset suppression to reduce the DC offset, such that the radio frequency receiver in the disclosure would not require an extra DC offset correction subsystem. Therefore, the radio frequency receiver in the disclosure would be a complete analog circuit that would be smaller, simpler, and easier to design and the hardware cost of the radio frequency receiver may also be reduced.

## Claims

1. An operational amplifier circuit (100, 100') with DC offset suppression, comprising:
a first operational amplifier (110) comprising:
an input stage (111) configured to receive differential input signals (i_p, i_n); and
an output stage (113) coupled to the input stage (111) and configured to output a pair of differential output signals (out_p, out_n); and
a pair of feedback circuits (120, 130, 120', 130') coupled to the output stage (113) of the first operational amplifier (110), wherein each of the pair of feedback circuits (120, 130, 120', 130') comprises a differential amplifier (140, 150) comprising a first input end (E41, E51) directly coupled to the output stage (113) to directly receive a corresponding one of the pair of differential output signals (out_p, out_n), a second input end (E42, E52) configured to receive a reference voltage (ref), and an output end (E43, E53) coupled to an end of a corresponding one of a pair of capacitors (C1, C2) and to a gate end of a corresponding one of a pair of bias transistors (M25, M26) of the output stage (113), to output a corresponding one of a pair of feedback signals (fb1, fb2) responding to a difference between the reference voltage (ref) and the corresponding one of the pair of differential output signals (out_p, out n);
wherein the pair of bias transistors (M25, M26) is configured to generate a pair of first bias currents (Ib1, Ib2) of the output stage (113), so that one of the pair of first bias currents (Ib1, Ib2) is adjusted based on a first feedback signal (fb1) of the pair of feedback signals (fb1, fb2), and another of the pair of first bias currents (Ib1, Ib2) is adjusted based on a second feedback signal (fb2) of the pair of feedback signals (fb1, fb2), so that a DC offset of one of the pair of differential output signals (out_p, out_n) is reduced based on the first feedback signal (fb1) instead of the second feedback signal (fb2), and a DC offset of another of the pair of differential output signals (out_p, out_n) is reduced based on the second feedback signal (fb2) instead of the first feedback signal (fb1).

2. The operational amplifier circuit (100, 100') with DC offset suppression according to claim 1, wherein the feedback circuit (120, 130, 120', 130') is a low frequency low-pass filter, and a cut-off frequency of the low frequency low-pass filter is lower than a frequency of the differential input signals (i_p, i_n).

3. The operational amplifier circuit (100) with DC offset suppression according to claim 1 or 2, wherein each of the pair of capacitors (C1, C2) is including another end coupled to a ground terminal (GND); and
each of the differential amplifiers is a second operational amplifier (op1, op2), wherein each first input end is a non-inverting input end (+), each second input end is an inverting input end (-).

4. The operational amplifier circuit (100') with DC offset suppression according to claim 1 or 2, wherein each of the pair of capacitors (C1, C2) is including another end coupled to a power terminal (Vdd); and
wherein each output end (E43, E53) of each of the differential amplifiers (140, 150) is located at a current path corresponding to each second input end (E42, E52) of each of the differential amplifiers (140, 150).

5. The operational amplifier circuit (100') with DC offset suppression according to claim 4, wherein each of the differential amplifiers (140, 150) comprises:
a first transistor (M41, M51), including a gate end coupled to the first operational amplifier (110) through the first input end (E41, E51) to receive the one of the pair of differential output signals (out_p, out_n);
a second transistor (M42, M52), including a gate end configured to receive the reference voltage (ref) through the second input end (E42, E52);
a current source circuit (142, 152), configured to generate a second bias current (Ib3, Ib4) to bias the first transistor (M41, M51) and the second transistor (M42, M52); and
a load circuit (144, 154), including a first load end coupled to a drain end of the first transistor (M41, M51), a second load end coupled to a drain end of the second transistor (M42, M52) to be the output end (E43, E53) of the differential amplifier (140, 150),
wherein the first transistor (M41, M51) further comprises a source end coupled to a bias node (bnl, bn2), the second transistor (M42, M52) further comprises a source end coupled to the source end of the first transistor (M41, M51), and the current source circuit (142, 152) is coupled to the bias node (bnl, bn2).

6. The operational amplifier circuit (100') with DC offset suppression according to claim 5, further comprising:
a bias current generating circuit (160), coupled to the current source circuits (142, 152) of the differential amplifiers (140, 150) respectively, and configured to generate a reference current (Iref) responding to a bias signal (BS),
wherein each of the current source circuits (142, 152) generates the second bias current (Ib3, Ib4) responding to the reference current (Iref).

7. The operational amplifier circuit (100') with DC offset suppression according to claim 6, wherein the bias current generating circuit (160) comprises:
a bias transistor (MB), including a gate end configured to receive the bias signal (BS), and a source end coupled to the power terminal (Vdd); and
a reference transistor (MR), including a source end coupled to a ground terminal (GND),
wherein a gate end and a drain end of the reference transistor (MR) are coupled to a drain end of the bias transistor (MB) and coupled to the current source circuits (142, 152) of the differential amplifiers (140, 150) respectively.

8. The operational amplifier circuit (100') with DC offset suppression according to claim 7, wherein each of the current source circuits (142, 152) comprises:
a third transistor (M43, M53), including a gate end coupled to the gate end of the reference transistor (MR), a drain end coupled to the bias node (bnl, bn2); and
a fourth transistor (M44, M54), including a drain end and a gate end coupled to each other and coupled to a source end of the third transistor (M43, M53), and a source end coupled to the ground terminal (GND).

9. A radio frequency (RF) receiver (200), comprising:
a mixer (220), configured to down-convert an RF signal (RFS) into a base band signal (BBS); and
a filtering module (240), coupled to the mixer (220) to receive the base band signal (BBS), and configured to output a filtered signal (FDS) by filtering and amplifying the base band signal (BBS),
wherein the filtering module (240) comprises:
a low pass filter (242), configured to receive a first signal (S1) or the base band signal (BBS) and output a second signal (S2) or the filtered signal (FDS)by filtering the first signal (S1) or the base band signal (BBS); and
a gain amplifier (300), comprising:
the operational amplifier circuit (100, 100') with DC offset suppression according to claim 1; and
a gain control circuit (310), configured to receive the base band signal (BBS) or the second signal (S2), and coupled between the input stage (111) and the output stage (113) to determine a gain value of the gain amplifier (300),
wherein the gain amplifier (300) is coupled between the mixer (220) and the low pass filter (242) to receive the base band signal (BBS), and configured to output the first signal (S1) by amplifying the base band signal (BBS); or
wherein the gain amplifier (300) is coupled to the low pass filter (242) to receive the second signal (S2), and configured to output the filtered signal (FDS) by amplifying the second signal (S2).

10. The RF receiver (200) according to claim 9, wherein the feedback circuit (120, 130, 120', 130') is a low frequency low-pass filter, and a cut-off frequency of the low frequency low-pass filter is lower than a frequency of the differential input signal (i_p, i_n).

11. The RF receiver according to claim 9 or 10, wherein each of the pair of capacitors (C1, C2) is including another end coupled to a ground terminal (GND); and each of the differential amplifiers is a second operational amplifier (op1, op2), wherein each first input end is a non-inverting input end (+), each second input end is an inverting input end (-).

12. The RF receiver according to claim 9 or 10, wherein each of the pair of capacitors (C1, C2) is including another end coupled to a power terminal (Vdd); and
wherein each output end (E43, E53) of each of the differential amplifiers (140, 150) is located at a current path corresponding to each second input end (E42, E52) of each of the differential amplifiers (140, 150).

13. The RF receiver (200) according to claim 12, wherein each of the differential amplifiers (140, 150) comprises:
a first transistor (M41, M51), including a gate end coupled to the first operational amplifier (110) through the first input end (E41, E51) to receive the one of the pair of differential output signals (out_p, out_n);
a second transistor (M42, M52), including a gate end configured to receive the reference voltage (ref) through the second input end (E42, E52);
a current source circuit (142, 152), configured to generate a second bias current (Ib3, Ib4) to bias the first transistor (M41, M51) and the second transistor (M42, M52); and
a load circuit (144, 154), including a first load end coupled to a drain end of the first transistor (M41, M51), a second load end coupled to a drain end of the second transistor (M42, M52) to be the output end (E43, E53) of the differential amplifier (140, 150),
wherein the first transistor (M41, M51) further comprises a source end coupled to a bias node (bnl, bn2), the second transistor (M42, M52) further comprises a source end coupled to the source end of the first transistor (M41, M51), and the current source circuit (142, 152) is coupled to the bias node (bnl, bn2).

14. The RF receiver (200) according to claim 13, wherein the differential amplifier (140, 150) further comprises:
a bias current generating circuit (160), coupled to the current source circuits (142, 152) of the differential amplifier (140, 150) respectively, and configured to generate a reference current (Iref) responding to a bias signal (BS),
wherein the current source circuit (142, 152) generates the second bias current (Ib3, Ib4) responding to the reference current (Iref).

15. A low pass filter (242), comprising:
the operational amplifier circuit (100, 100') with DC offset suppression according to claim 1; and
a filtering circuit (242_1), configured to receive an external signal, and coupled between the input stage (111) and the output stage (113) to amplify and filter the external signal.

## Patentansprüche

1. Operationsverstärkerschaltung (100, 100') mit DC-Offsetunterdrückung, umfassend:
einen ersten Operationsverstärker (110), der umfasst:
eine Eingangsstufe (111), die konfiguriert ist, um differentielle Eingangssignale (i_p, i_n) zu empfangen; und
eine Ausgangsstufe (113), die mit der Eingangsstufe (111) gekoppelt und konfiguriert ist, um ein Paar differentieller Ausgangssignale (out_p, out_n) auszugeben; und
ein Paar Rückkopplungsschaltungen (120, 130, 120', 130', 130'), die mit der Ausgangsstufe (113) des ersten Operationsverstärkers (110) gekoppelt sind, wobei jede der beiden Rückkopplungsschaltungen (120, 130, 120', 130') einen Differenzverstärker (140, 150) umfasst, der ein erstes Eingangsende (E41, E51) umfasst, das direkt mit der Ausgangsstufe (113) gekoppelt ist, um direkt ein entsprechendes aus dem Paar differentieller Ausgangssignale (out_p, out_n) zu empfangen, der ein zweites Eingangsende (E42, E52) umfasst, das konfiguriert ist, um eine Referenzspannung (ref) zu empfangen, und der ein Ausgangsende (E43, E53) umfasst, das mit einem Ende eines entsprechenden Kondensators aus einem Paar Kondensatoren (C1, C2) und mit einem Gate-Ende eines entsprechenden aus einem Paar Vorspannungstransistoren (M25, M26) der Endstufe (113) gekoppelt ist, um ein entsprechendes aus einem Paar Rückkopplungssignale (fb1, fb2) auszugeben, die auf eine Differenz zwischen der Referenzspannung (ref) und dem entsprechenden aus dem Paar differentieller Ausgangssignale (out_p, out_n) reagieren;
wobei das Paar von Vorspannungstransistoren (M25, M26) konfiguriert ist, um ein Paar erster Vorspannungströme (Ib1, Ib2) der Endstufe (113) zu erzeugen, so dass einer der ersten Vorspannungströme (Ib1, Ib2) basierend auf einem ersten Rückkopplungssignal (fb1) des Paares von Rückkopplungssignalen (fb1, fb2) eingestellt wird, und
ein weiterer des Paares der ersten Vorspannungsströme (Ib1, Ib2) basierend auf einem zweiten Rückkopplungssignal (fb2) des Paares der Rückkopplungssignale (fb1, fb2) eingestellt wird, so dass ein DC-Offset eines der beiden differentiellen Ausgangssignale (out_p.) out_n) basierend auf dem ersten Rückkopplungssignal (fb1) anstelle des zweiten Rückkopplungssignals (fb2) reduziert wird, und ein DC-Offset eines anderen des Paares von differentiellen Ausgangssignalen (out_p, out_n) basierend auf dem zweiten Rückkopplungssignal (fb2) anstelle des ersten Rückkopplungssignals (fb1) reduziert wird.

2. Operationsverstärkerschaltung (100, 100') mit DC-Offsetunterdrückung nach Anspruch 1, wobei die Rückkopplungsschaltung (120, 130, 120', 130') ein Niederfrequenz-Tiefpassfilter ist und eine Grenzfrequenz des Niederfrequenz-Tiefpassfilters niedriger ist als eine Frequenz der differentiellen Eingangssignale (i_p, i_n).

3. Operationsverstärkerschaltung (100) mit DC-Offsetunterdrückung nach Anspruch 1 oder 2, wobei jedes Paar von Kondensatoren (C1, C2) ein weiteres Ende beinhaltet, das mit einer Erdungsklemme (GND) gekoppelt ist; und jeder der Differenzverstärker ein zweiter Operationsverstärker (op1, op2) ist, wobei jedes erste Eingangsende ein nicht-invertierendes Eingangsende (+) ist, jedes zweite Eingangsende ein invertierendes Eingangsende (-) ist.

4. Die Operationsverstärkerschaltung (100') mit DC-Offsetunterdrückung nach Anspruch 1 oder 2, wobei jedes der Paar von Kondensatoren (C1, C2) ein weiteres Ende beinhaltet, das mit einem Stromanschluss (Vdd) gekoppelt ist; und wobei jedes Ausgangsende (E43, E53) jedes der Differenzverstärker (140, 150) an einem Strompfad angeordnet ist, der jedem zweiten Eingangsende (E42, E52) jedes der Differenzverstärker (140, 150) entspricht.

5. Operationsverstärkerschaltung (100') mit DC-Offsetunterdrückung nach Anspruch 4, wobei jeder der Differenzverstärker (140, 150) umfasst:
einen ersten Transistor (M41, M51), der ein Gate-Ende beinhaltet, das über das erste Eingangsende (E41, E51) mit dem ersten Operationsverstärker (110) gekoppelt ist, um das eine aus dem Paar differentieller Ausgangssignale (out_p, out_n) zu empfangen;
einen zweiten Transistor (M42, M52), der ein Gate-Ende beinhaltet, das konfiguriert ist, um die Referenzspannung (ref) durch das zweite Eingangsende (E42, E52) zu empfangen;
eine Stromquellenschaltung (142, 152), die konfiguriert ist, um einen zweiten Vorspannungsstrom (Ib3, Ib4) zum Vorspannen des ersten Transistors (M41, M51) und des zweiten Transistors (M42, M52) zu erzeugen; und
eine Lastschaltung (144, 154), die ein erstes Lastende, das mit einem Drain-Ende des ersten Transistors (M41, M51) gekoppelt ist, ein zweites Lastende, das mit einem Drain-Ende des zweiten Transistors (M42, M52) gekoppelt ist, um das Ausgangsende (E43, E53) des Differenzverstärkers (140, 150) zu sein,
wobei der erste Transistor (M41, M51) ferner ein Source-Ende umfasst, das mit einem Vorspannungsknoten (bnl, bn2) gekoppelt ist, der zweite Transistor (M42, M52) ferner ein Source-Ende umfasst, das mit dem Source-Ende des ersten Transistors (M41, M51) gekoppelt ist, und die Stromquellenschaltung (142, 152) mit dem Vorspannungsknoten (bn1, bn2) gekoppelt ist.

6. Operationsverstärkerschaltung (100') mit DC-Offsetunterdrückung nach Anspruch 5, ferner umfassend:
eine Vorspannungsstrom-Erzeugungsschaltung (160), die mit den Stromquellenschaltungen (142, 152) der Differenzverstärker (140, 150) gekoppelt und konfiguriert ist, um einen Referenzstrom (Iref) zu erzeugen, der auf ein Vorspannungssignal (BS) reagiert,
wobei jede der Stromquellenschaltungen (142, 152) den zweiten Vorspannungsstrom (Ib3, Ib4) erzeugt, der auf den Referenzstrom (Iref) reagiert.

7. Operationsverstärkerschaltung (100') mit DC-Offsetunterdrückung nach Anspruch 6, wobei die Vorspannungsstrom-Erzeugungsschaltung (160) umfasst:
einen Vorspannungstransistor (MB), der ein Gate-Ende, das zum Empfangen des Bias-Signals (BS) konfiguriert ist, und ein mit dem Stromanschluss (Vdd) gekoppeltes Source-Ende beinhaltet; und
einen Referenztransistor (MR), der ein Source-Ende beinhaltet, das mit einer Erdungsklemme (GND) gekoppelt ist,
wobei ein Gate-Ende und ein Drain-Ende des Referenztransistors (MR) mit einem Drain-Ende des Vorspannungstransistors (MB) gekoppelt und mit den Stromquellenschaltungen (142, 152) der Differenzverstärker (140, 150) gekoppelt sind.

8. Operationsverstärkerschaltung (100')mit DC-Offsetunterdrückung nach Anspruch 7, wobei jede der Stromquellenschaltungen (142, 152) umfasst:
einen dritten Transistor (M43, M53), der ein Gate-Ende, das mit dem Gate-Ende des Referenztransistors (MR) gekoppelt ist, und ein Drain-Ende, das mit dem Vorspannungsknoten (bnl, bn2) gekoppelt ist, beinhaltet; und
einen vierten Transistor (M44, M54), der ein Drain-Ende und ein Gate-Ende aufweist, die miteinander gekoppelt und mit einem Source-Ende des dritten Transistors (M43, M53) gekoppelt sind, und ein Source-Ende, das mit dem Masseanschluss (GND) gekoppelt ist.

9. Funkfrequenz (RF)-Empfanger (200), umfassend:
einen Mischer (220), der konfiguriert ist, um ein HF-Signal (RFS) in ein Basisbandsignal (BBS) herunterzuwandeln; und
ein Filtermodul (240), das mit dem Mischer (220) gekoppelt ist, um das Basisbandsignal (BBS) zu empfangen, und konfiguriert ist, um ein gefiltertes Signal (FDS) durch Filtern und Verstärken des Basisbandsignals (BBS) auszugeben,
wobei das Filtermodul (240) umfasst:
einen Tiefpassfilter (242), der konfiguriert ist, um ein erstes Signal (S1) oder das Basisbandsignal (BBS) zu empfangen und ein zweites Signal (S2) oder das gefilterte Signal (FDS) durch Filtern des ersten Signals (S1) oder des Basisbandsignals (BBS) auszugeben; und
einen Gain-Verstärker (300), umfassend:
die Operationsverstärkerschaltung (100, 100') mit DC-Offsetunterdrückung nach Anspruch 1; und
eine Verstärkungssteuerschaltung (310), die konfiguriert ist, um das Basisbandsignal (BBS) oder das zweite Signal (S2) zu empfangen, und zwischen der Eingangsstufe (111) und der Ausgangsstufe (113) gekoppelt ist, um einen Verstärkungswert des Gain-Verstärkers (300) zu bestimmen,
wobei der Gain-Verstärker (300) zwischen dem Mischer (220) und dem Tiefpassfilter (242) gekoppelt ist, um das Basisbandsignal (BBS) zu empfangen, und konfiguriert ist, um das erste Signal (S1) durch Verstärken des Basisbandsignals (BBS) auszugeben; oder
wobei der Gain-Verstärker (300) mit dem Tiefpassfilter (242) gekoppelt ist, um das zweite Signal (S2) zu empfangen, und konfiguriert ist, um das gefilterte Signal (FDS) durch Verstärken des zweiten Signals (S2) auszugeben,

10. RF-Empfänger (200) nach Anspruch 9, wobei die Rückkopplungsschaltung (120, 130, 120', 130', 130') ein Niederfrequenz-Tiefpassfilter ist und eine Trennfrequenz des Niederfrequenz-Tiefpassfilters niedriger ist als eine Frequenz des differentiellen Eingangssignals (i_p, i_n).

11. RF-Empfänger nach Anspruch 9 oder 10, wobei jedes der Paar von Kondensatoren (C1, C2) ein weiteres Ende beinhaltet, das mit einem Erdungsanschluss (GND) gekoppelt ist; und
jeder der Differenzverstärker ein zweiter Operationsverstärker (op1, op2) ist, wobei jedes erste Eingangsende ein nicht-invertierendes Eingangsende (+) ist, jedes zweite Eingangsende ein invertierendes Eingangsende (-) ist.

12. RF-Empfänger nach Anspruch 9 oder 10, wobei jedes der Paar von Kondensatoren (C1, C2) ein weiteres Ende beinhaltet, das mit einem Stromanschluss (Vdd) gekoppelt ist; und
wobei jedes Ausgangsende (E43, E53) jedes der Differenzverstärker (140, 150) an einem Strompfad angeordnet ist, der jedem zweiten Eingangsende (E42, E52) jedes der Differenzverstärker (140, 150) entspricht.

13. RF-Empfänger (200) nach Anspruch 12, wobei jeder der Differenzverstärker (140, 150) umfasst:
einen ersten Transistor (M41, M51), der ein Gate-Ende beinhaltet, das über das erste Eingangsende (E41, ES1) mit dem ersten Operationsverstärker (110) gekoppelt ist, um das eine aus dem Paar differentieller Ausgangssignale (out_p, out_n) zu empfangen;
einen zweiten Transistor (M42, M52), der ein Gate-Ende beinhaltet, das konfiguriert ist, um die Referenzspannung (ref) durch das zweite Eingangsende (E42, E52) zu empfangen;
eine Stromquellenschaltung (142, 152), die konfiguriert ist, um einen zweiten Vorspannungsstrom (Ib3, Ib4) zum Vorspannen des ersten Transistors (M41, M51) und des zweiten Transistors (M42, M52) zu erzeugen; und
eine Lastschaltung (144, 154), die ein erstes Lastende, das mit einem Drain-Ende des ersten Transistors (M41, M51) gekoppelt ist, ein zweites Lastende, das mit einem Drain-Ende des zweiten Transistors (M42, M52) gekoppelt ist, um das Ausgangsende (E43, E53) des Differenzverstärkers (140, 150) zu sein,
wobei der erste Transistor (M41, M51) ferner ein Source-Ende umfasst, das mit einem Vorspannungsknoten (bnl, bn2) gekoppelt ist, der zweite Transistor (M42, M52) ferner ein Source-Ende umfasst, das mit dem Source-Ende des ersten Transistors (M41, M51) gekoppelt ist, und die Stromquellenschaltung (142, 152) mit dem Vorspannungsknoten (bnl, bn2) gekoppelt ist.

14. RF-Empfänger (200) nach Anspruch 13, wobei der Differenzverstärker (140, 150) ferner umfasst:
eine Vorspannungsstrom-Erzeugungsschaltung (160), die mit den Stromquellenschaltungen (142, 152) des Differenzverstärkers (140, 150) gekoppelt und konfiguriert ist, um einen Referenzstrom (Iref) zu erzeugen, der auf ein Vorspannungssignal (BS) reagiert,
wobei die Stromquellenschaltung (142, 152) den zweiten Vorspannungsstrom (Ib3, Ib4) erzeugt, der auf den Referenzstrom (Iref) reagiert.

15. Tiefpassfilter (242), umfassend:
die Operationsverstärkerschaltung (100, 100') mit DC-Offsetunterdrückung nach Anspruch 1; und
eine Filterschaltung (242_1), die zum Empfangen eines externen Signals konfiguriert ist und zwischen der Eingangsstufe (111) und der Ausgangsstufe (113) gekoppelt ist, um das externe Signal zu verstärken und zu filtern.

## Revendications

1. Un circuit amplificateur opérationnel (100, 100') avec suppression de décalage de niveau continu, comprenant:
un premier amplificateur opérationnel (110) comprenant:
un étage d'entrée (111) configuré pour recevoir des signaux d'entrée différentiels (i_p, i_n); et
un étage de sortie (113) couplé à l'étage d'entrée (111) et configuré pour sortir une paire de signaux de sortie différentiels (out_p, out_n); et
une paire de circuits de rétroaction (120, 130, 120', 130') couplés à l'étage de sortie (113) du premier amplificateur opérationnel (110), dans lequel chaque circuit de la paire de circuits de rétroaction (120, 130, 120 ', 130 ') comporte un amplificateur différentiel (140, 150) comprenant une première entrée (E41, E51) directement couplée à l'étage de sortie (113) pour directement recevoir un signal correspondant parmi la paire de signaux de sortie différentiels (out_p, out_n), une seconde entrée (E42, E52) configurée pour recevoir une tension de référence (ref), et une extrémité de sortie (E43, E53) couplée à une extrémité d'une capacité correspondante parmi une pair de capacités (C1, C2) et une extrémité de grille d'un transistor correspondant d'une paire de transistor de polarisation (M25, M26) de l'étage de sortie (113), pour générer en sortie un signal correspondant parmi une paire de signaux de rétroaction (fb1, fb2) répondant à une différence entre la tension de référence (ref) et le signal correspondant parmi la paire de signaux de sortie différentiels (out_p, out_n) ;
dans lequel la paire de transistors de polarisation (M25, M26) est configurée pour générer une paire de premiers courants de polarisation (Ib1, Ib2) de l'étage de sortie (113), de telle manière qu'un courant parmi la paire de premiers courants de polarisation (Ib1, Ib2) est réglée sur la base d'un premier signal de contre-réaction (fb1) de la paire de signaux de contre-réaction (fb1, fb2), et un autre courant de la paire de premiers courants de polarisation (Ib1, Ib2) est réglée sur la base d'un second signal de rétro-action (fb2) de la paire de signaux de rétro-action (fb1, fb2), de telle manière qu'un décalage de continu d'un signal parmi la paire de signaux de sortie différentiels (out_p, out_n) est réduit sur la base du premier signal de contre-réaction (fb1) au lieu du second signal de contre-réaction (fb2), et un décalage continu d'un autre signal parmi la paire de signaux de sortie différentiels (out_p, out_n) est réduite sur la base du second signal de contre-réaction (fb2) au-lieu du premier signal de contre-réaction (fb1).

2. Le circuit amplificateur opérationnel (100, 100') avec suppression de décalage en courant continu selon la revendication 1, dans lequel le circuit de réaction (120, 130, 120', 130') est un filtre passe-bas basse fréquence et une fréquence de coupure du filtre passe-bas basse fréquence est inférieur à la fréquence des signaux d'entrée différentiels (i_p, i_n).

3. Le circuit amplificateur opérationnel (100) avec suppression de décalage en courant continu selon la revendication 1 ou 2, dans lequel chaque paire de capacités (C1, C2) comporte une autre extrémité couplée à une électrode de terre (GND) ; et chacun des amplificateurs différentiels est un second amplificateur opérationnel (op1, op2), dans lequel chaque première entrée est une entrée non inverseuse (+), chaque seconde entrée est une entrée inverseuse (-).

4. Le circuit amplificateur opérationnel (100 ') avec suppression de décalage en courant continu selon la revendication 1 ou 2, dans lequel chaque paire de capacités (C1, C2) comporte une autre extrémité couplée à une électrode d'alimentation (Vdd) ; et
dans lequel chaque extrémité de sortie (E43, E53) de chacun des amplificateurs différentiels (140, 150) est situé à un chemin de courant correspondant à chacune des secondes entrées (E42, E52) de chacun des amplificateurs différentiels (140, 150).

5. Le circuit amplificateur opérationnel (100') avec suppression de décalage en courant continu selon la revendication 4, dans lequel chacun des amplificateurs différentiels (140, 150) comprend:
un premier transistor (M41, M51) comprenant une extrémité de grille couplée au premier amplificateur opérationnel (110) à travers la première extrémité d'entrée (E41, E51) pour recevoir l'un des deux signaux de sortie différentiels (out_p, out_n);
un second transistor (M42, M52) comprenant une extrémité de grille configurée pour recevoir la tension de référence (ref) à travers la seconde entrée (E42, E52);
un circuit de source de courant (142, 152), configuré pour générer un second courant de polarisation (Ib3, Ib4) pour polariser le premier transistor (M41, M51) et le second transistor (M42, M52); et
un circuit de charge (144, 154) comprenant une première extrémité de charge couplée à une extrémité de drain du premier transistor (M41, M51), une seconde extrémité de charge couplée à une extrémité de drain du second transistor (M42, M52) devant être l'extrémité de sortie (E43, E53) de l'amplificateur différentiel (140, 150),
dans lequel le premier transistor (M41, M51) comprend en outre une extrémité de source couplée à un noeud de polarisation (bn1, bn2), le second transistor (M42, M52) comprend en outre une extrémité de source couplée à l'extrémité de source du premier transistor (M41, M51) et le circuit de source de courant (142, 152) est couplé au noeud de polarisation (bn1, bn2).

6. Le circuit amplificateur opérationnel (100') avec suppression de décalage de courant continu selon la revendication 5, comprenant en outre:
un circuit de génération de courant de polarisation (160), couplé aux circuits de source de courant (142, 152) des amplificateurs différentiels (140, 150) respectivement, et configuré pour générer un courant de référence (Iref) répondant à un signal de polarisation (BS),
dans lequel chacun des circuits de source de courant (142, 152) génère le second courant de polarisation (Ib3, Ib4) répondant au courant de référence (Iref).

7. Le circuit amplificateur opérationnel (100') avec suppression de décalage en courant continu selon la revendication 6, dans lequel le circuit générateur de courant de polarisation (160) comprend:
un transistor de polarisation (MB) comprenant une extrémité de grille configurée pour recevoir le signal de polarisation (BS), et une extrémité de source couplée à la borne d'alimentation (Vdd); et
un transistor de référence (MR) comprenant une extrémité de source couplée à une borne de masse (GND),
dans lequel une extrémité de grille et une extrémité de drain du transistor de référence (MR) sont couplées à une extrémité de drain du transistor de polarisation (MB) et couplés aux circuits de source de courant (142, 152) des amplificateurs différentiels (140, 150) respectivement.

8. Le circuit amplificateur opérationnel (100') avec suppression de décalage en courant continu selon la revendication 7, dans lequel chacun des circuits de source de courant (142, 152) comprend:
un troisième transistor (M43, M53) comprenant une extrémité de grille couplée à l'extrémité de porte du transistor de référence (MR), une extrémité de drain étant couplée au noeud de polarisation (bn1, bn2); et
un quatrième transistor (M44, M54) comprenant une extrémité de drain et une extrémité de grille couplées l'une à l'autre et couplées à une extrémité de source du troisième transistor (M43, M53) et une extrémité de source couplée à la borne de masse (GND).

9. Un récepteur radiofréquence (RF) (200), comprenant:
un mélangeur (220) configuré pour convertir un signal RF (RFS) en un signal en bande de base (BBS); et
un module de filtrage (240), couplé au mélangeur (220) pour recevoir le signal de bande de base (BBS), et configuré pour générer en sortie un signal filtré (FDS) au moyen d'une filtration et pour amplifier le signal en bande de base (BBS),
dans lequel le module de filtrage (240) comporte :
un filtre passe-bas (242), configuré pour recevoir un premier signal (S1) ou le signal de bande de base (BBS) et pour générer un second signal (S2) ou le signal filtré (FDS) en filtrant le premier signal (S1) ou le signal en bande de base (BBS) ; et
un amplificateur de gain (300) comprenant:
un circuit amplificateur opérationnel (100, 100') avec suppression de décalage de courant continu selon la revendication 1 ; et
un circuit de commande de gain (310), configuré pour recevoir le signal de bande de base (BBS) ou le second signal (S2), et couplé entre l'étage d'entrée (111) et l'étage de sortie (113) pour déterminer une valeur de gain de l'amplificateur de gain (300),
dans lequel l'amplificateur de gain (300) est couplé entre le mélangeur (220) et le filtre passe bas (242) pour recevoir le signal de bande de base (BBS), et configuré pour générer en sortie le premier signal (S1) par une amplification du signal de bande de base (BBS) ; ou
dans lequel l'amplificateur de gain (300) est couplé au filtre passe-bas (242) pour recevoir le second signal (S2), et configuré pour générer en sortie le signal filtré (FDS) par une amplification du second signal (S2).

10. Le récepteur RF (200) selon la revendication 9, dans lequel le circuit de contre-réaction (120, 130, 120', 130') est un filtre passe-bas basse fréquence, et une fréquence de coupure du filtre passe-bas basse fréquence est inférieure à une fréquence du signal d'entrée différentiel (i_p, i_n).

11. Le récepteur RF selon la revendication 9 ou 10, dans lequel chaque capacité de la paire de capacités (C1, C2) comporte une autre extrémité couplée à une électrode de terre (GND) ; et
chacun des amplificateurs différentiels est un second amplificateur opérationnel (op1, op2), dans lequel chaque première entrée est une entrée non inverseuse et (+), chaque seconde entrée est une entrée inverseuse (-).

12. Le récepteur RF selon la revendication 9 ou 10, dans lequel chaque capacité de la paire de capacité (C1, C2) comportant une autre extrémité couplée à une électrode d'alimentation (Vdd) ; et
dans lequel chaque extrémité de sortie (E43, E53) de chaque amplificateurs différentiels (140, 150) est situé à un chemijn de courant correspondant à chaque seconde extrémité d'entrée (E42, E52) de chaque amplificateur différentiel (140, 150).

13. Le récepteur RF (200) selon la revendication 12, dans lequel chacun des amplificateurs différentiels (140, 150) comprend:
un premier transistor (M41, M51), comprenant une extrémité de grille couplée au premier amplificateur opérationnel (110) via la première entrée (E41, E51) pour recevoir l'un des deux signaux de sortie différentiels (out_p, out_n);
un second transistor (M42, M52), comprenant une extrémité de grille configurée pour recevoir la tension de référence (ref) à travers la seconde entrée (E42, E52);
un circuit de source de courant (142, 152), configuré pour générer un second courant de polarisation (Ib3, Ib4) pour polariser le premier transistor (M41, M51) et le second transistor (M42, M52); et
un circuit de charge (144, 154) comprenant une première extrémité de charge couplée à une extrémité de drain du premier transistor (M41, M51), une seconde extrémité de charge couplée à une extrémité de drain du second transistor (M42, M52) devant être l'extrémité de sortie (E43, E53) de l'amplificateur différentiel (140, 150),
dans lequel le premier transistor (M41, M51) comprend en outre une extrémité de source couplée à un noeud de polarisation (bn1, bn2), le second transistor (M42, M52) comprenant en outre une extrémité de source couplée à l'extrémité de source du premier transistor (M41, M51), et le circuit de source de courant (142, 152) étant couplé au noeud de polarisation (bn1, bn2).

14. Le récepteur RF (200) selon la revendication 13, dans lequel l'amplificateur différentiel (140, 150) comprend en outre:
un circuit de génération de courant de polarisation (160), couplé aux circuits de source de courant (142, 152) de l'amplificateur différentiel (140, 150) respectivement, et configuré pour générer un courant de référence (Iref) répondant à un signal de polarisation (BS),
dans lequel le circuit de source de courant (142, 152) génère le second courant de polarisation (Ib3, Ib4) répondant au courant de référence (Iref).

15. Un filtre passe-bas (242) comprenant:
le circuit amplificateur opérationnel (100, 100') avec suppression de décalage en courant continu selon la revendication 1, et
un circuit de filtrage (242_1) configuré pour recevoir un signal externe et couplé entre l'étage d'entrée (111) et l'étage de sortie (113) pour amplifier et filtrer le signal externe.
